# EUROPÄISCHE PATENTSCHRIFT

(11) **EP 2 286 275 B1**
(45) Veröffentlichungstag und Bekanntmachung des Hinweises auf die Patenterteilung: **29.08.2012**
(21) Anmeldenummer: 09761643.7
(22) Anmeldetag: 03.06.2009
(51) Int. Cl.: H01J 37/244, H01J 37/28, H01J 37/256

(54) **SENSORKOPF FÜR EINEN RÖNTGENDETEKTOR SOWIE DIESEN SENSORKOPF ENTHALTENDER RÖNTGENDETEKTOR**
SENSOR HEAD FOR AN X-RAY DETECTOR AND X-RAY DETECTOR CONTAINING SAID SENSOR HEAD
TÊTE DE DÉTECTION POUR DÉTECTEUR DE RAYONS X ET DÉTECTEUR DE RAYONS X MUNI DE CETTE TÊTE DE DÉTECTION

(30) Priorität: 13.06.2008 DE 102008028487
(43) Veröffentlichungstag der Anmeldung: 23.02.2011
(73) Patentinhaber: Bruker Nano GmbH, 12489 Berlin (DE)
(72) Erfinder: KRÖMER, Robert, 12105 Berlin (DE)
(74) Vertreter: Gulde Hengelhaupt Ziebig & Schneider
(86) Internationale Anmeldenummer: PCT/EP2009/056779
(87) Internationale Veröffentlichungsnummer: WO 2009/150080

(56) Entgegenhaltungen:
- JP-A- 4 061 173
- JP-A- 10 012 851
- US-A- 4 810 881

## Beschreibung

Die Erfindung betrifft einen Sensorkopf für einen Röntgendetektor sowie einen den Sensorkopf enthaltenden Röntgendetektor, insbesondere für die Elektronenstrahlmikroanalyse.

Die Elektronenstrahlmikroanalyse ist eine weit verbreitete Methode der Elementaranalytik. Dabei wird Röntgenstrahlung, die in einem Elektronenmikroskop, insbesondere einem Rasterelektronenmikroskop (REM), bei der Abtastung einer Probe durch einen Elektronenstrahl entsteht, detektiert und ausgewertet. Zunächst nur als Spezialanwendung in Zusammenhang mit hierfür besonders ausgelegten Geräten wie z.B. Elektronenstrahl-Mikrosonden geplant, hat sich die Elektronenstrahlmikroanalyse zwischenzeitlich zu einer in praktisch jedem REM-Labor routinemäßig angewendeten Methode entwickelt.

Der entscheidende Schritt hierfür war die Einführung von energiedispersiven Röntgendetektoren (EDX-Detektoren), die sich durch ihre einfache und robuste Bauweise, Wartungsarmut, stabile Arbeitsweise und nicht zuletzt dem relativ großen erfassten Raumwinkel (engl. solid angle) auszeichnen.

EDX-Detektoren verfügen über ein Eingangsfenster, einen Halbleiterkristall, der axial in Sichtachse des Detektors auf einem sogenannten Kühlfinger angeordnet ist, und eine Verstärkereinheit, die typischerweise einen Feldeffekt-Transistor (FET) und einen Vorverstärker aufweist. Ein EDX-Detektor weist ein relativ großes, homogenes Volumen auf, das Röntgenstrahlung aus nahezu beliebiger Richtung erfassen kann. Insbesondere der große Raumwinkel der von EDX-Detektoren erfassten Röntgenstrahlung, d.h. der große Anteil der genutzten Strahlung an der insgesamt erzeugten, gestattet es, eine Mikroanalyse an gebräuchlichen, abbildenden Elektronenmikroskopen durchzuführen.

JP 10 012851 A (HAMAMATSU PHOTONICS KK; MITSUBISHI ELECTRIC CORP) 16. Januar 1998 (1998-01-16) offenbart ein Gerät zur Bildgebung mittels Strahlung

US 4 810 881 A (BERGER JEAN L [FR] ET AL) 7. März 1989 (1989-03-07) offenbart ein Panel für die Röntgenphotographie und dessen Herstellungsmethode

JP 4 061173 A (NIPPON MINING CO) 27. Februar 1992 (1992-02-27) offenbart die Herstellung eines Halbleiter-Strahlungsdetektors.

Die Entwicklung der REMs hin zu immer besserer elektronenoptischer Auflösung, die Verbesserung der Elektronendetektoren, aber auch das vermehrte Interesse an organischen oder anderweitig empfindlichen Proben, haben den üblichen Strahlstrom soweit sinken lassen, dass in vielen Fällen auch mit EDX-Detektoren deutliche Grenzen gesetzt sind. Diese können derzeit nur durch extrem lange Messzeiten kompensiert werden.

Besonders deutlich wird das Problem bei sogenannten SDD-Detektoren (Siliziumdriftdetektor, silicon drift detector), die von ihrer physikalischen Wirkungsweise und Bauart her ein Vielfaches der üblichen Strahlungsmenge erfassen könnten. Bei proben- oder gerätebedingter Begrenzung des Strahlstromes besteht der einzige Weg, die erfasste Strahlungsmenge zu vergrößern und damit die Messzeit zu verringern, darin, den vom Detektor erfassten Raumwinkel der Strahlung zu erhöhen. Zu diesem Zweck ist ein möglichst geringer Abstand des Detektors zu der Probe wünschenswert.

Dies ist jedoch durch die Detektorgröße und die baulichen Gegebenheiten des Elektronenmikroskops limitiert. Der zur Bilderzeugung optimale Arbeitsabstand zwischen Polschuh und Probe liegt im Elektronenmikroskop bei ca. 4 mm, wobei eine Vergrößerung dieses Arbeitsabstandes die Bildqualität verschlechtert. Um den EDX-Detektor möglichst nah an der Probe zu positionieren, müsste der Detektorfinger optimalerweise zwischen Polschuh und Probe im Elektronenmikroskop positioniert werden. Somit besteht das Bedürfnis, die Detektorfinger von EDX-Detektoren möglichst klein zu dimensionieren, um den Arbeitsabstand im Elektronenmikroskop nicht unnötig vergrößern zu müssen.

Von dieser Reduzierung darf der Sensorchip des SDD-Detektors nicht betroffen sein, da sonst die erfasste Strahlungsmenge und somit die Sensitivität des SDD-Detektors ebenfalls vermindert würde.

Es ist daher die Aufgabe der vorliegenden Erfindung die Detektorgröße eines Röntgendetektors, insbesondere eines SDD-Detekors, idealerweise unter Beibehaltung der Sensorchipfläche zu minimieren.

Die Aufgabe wird nach einem ersten Aspekt der Erfindung durch einen Sensorkopf mit den Merkmalen des Anspruchs 1 gelöst. Weitere erfindungsgemäße Ausgestaltungen sind mit den Merkmalen der Unteransprüche beschrieben.

Die Erfindung betrifft einen Sensorkopf für einen Röntgendetektor, umfassend eine Leiterplatte mit einer Stirnfläche und Seitenflächen, einen auf der Stirnfläche der Leiterplatte angeordneten für Röntgenstrahlung empfindlichen Sensorchip, eine Mehrzahl von Signal- und Steueranschlüssen zum Betrieb des sensorchips, die unterhalb, d.h. auf, der von der Stirnfläche abgewandten seite der Leiterplatte angeordnet sind eine Mehrzahl von an der Leiterplatte kontaktierend angeordneten Bondinseln, von denen mindestens ein Teil über jeweils mindestens einen Bonddraht mit den Signal- und Steueranschlüssen elektrisch leitfähig verbunden ist, wobei die Bondinseln an den Seitenflächen der Leiterplatte angeordnet sind; oder die Leiterplatte an den Seitenflächen Aussparungen aufweist und die Bondinseln auf der Stirnfläche der Leiterplatte jeweils neben einer Aussparung angeordnet sind, wobei die Signal- und Steueranschlüsse unterhalb der Aussparungen enden oder in diese hineinreichen

Die erfindungsgemäße Anordnung der Bondinseln an den Seitenflächen der Leiterplatte ermöglicht zusammen mit einem seitlichen Bonden der Bonddrähte eine platzsparende Anordnung der Bauteile des Sensorkopfes, was insgesamt eine Verkleinerung des Sensorkopfes ermöglicht.

Alternativ werden die Signal- und Steueranschlüsse in die Aussparungen der Leiterplatte eingerückt. Auch diese Anordnung der Bauteile des Sensorkopfes ist äußerst platzsparend und ermöglicht insgesamt eine deutliche Verkleinerung des Sensorkopfes.

In einer bevorzugten Ausgestaltung der Erfindung besitzt die Stirnfläche der Leiterplatte einen achteckigen Umriss, wobei die gegenüberliegenden Seitenflächen gleichlang und die nebeneinanderliegenden Seitenflächen unterschiedlich lang sind. In einer besonders bevorzugten Ausführungsform besitzt die Leiterplatte vier einander gegenüberliegende lange Seitenflächen und vier einander gegenüberliegende kurze Seitenflächen, die abwechselnd angeordnet sind. Insbesondere der achteckige Umriss der Stirnfläche spart die ungenutzten Eckbereiche einer üblicherweise viereckigen Stirnfläche ein und ermöglicht eine optimalere Anpassung an den üblicherweise rund ausgestalteten Sensorkopf.

Dabei werden vorzugsweise die Bondinseln an den langen Seitenflächen angeordnet, wobei vorzugsweise zwei bis acht, insbesondere drei bis sechs und am meisten bevorzugt drei oder vier Bondinseln pro langer Seitenfläche vorhanden sind. Insgesamt weist die Leiterplatte mindestens sechs Bondinseln auf, die vorzugsweise regelmäßig auf der Leiterplatte angeordnet sind.

Zwischen den einzelnen Bondinseln befindet sich ein Abstand, der möglichst klein gewählt wird, wobei der Abstand einen Minimalabstand nicht unterschreiten darf. Dieser Minimalabstand muss genau so groß sein, dass die Bondinseln untereinander keinen elektrischen Kontakt aufweisen. Vorzugsweise ist der Abstand zwischen den Mittelpunkten der Bondinseln kleiner als 2 mm. Besonders bevorzugt wird ein Abstand von 1,5 mm und/oder 1,4 mm zwischen den Mittelpunkten der Bondinseln gewählt. Insbesondere entspricht der Abstand zwischen den Bondinseln dem Abstand zwischen den Signal- und Steueranschlüssen.

In einer weiteren bevorzugten Ausführungsform weist die Leiterplatte an den langen Seitenflächen Aussparungen auf. Die Bondinseln sind in dieser Ausführungsform in den Aussparungen angeordnet. Die seitliche Ausdehnung der Aussparungen entspricht der seitlichen Ausdehnung der Bondinseln. Der Abstand zwischen den Mittelpunkten der Bondinseln entspricht dem Abstand bei der Ausführungsform ohne Aussparungen.

Die Gesamtlänge der langen Seitenflächen entspricht mindestens dem Produkt aus der maximalen Anzahl der pro Seite angeordneten Bondinseln und deren Abstand A zueinander. Die Gesamtlänge der kurzen Seitenflächen wird derart gewählt, dass sich beim Verbinden der langen Seitenflächen eine achteckige Fläche ergibt.

Als Basismaterial für die erfindungsgemäße Leiterplatte kommen alle im Stand der Technik bekannten Materialien in Frage. Beispielsweise kann mit Phenolharz oder Epoxidharz getränktes Papier, mit Epoxidharz getränktes Glasfasergewebe, Teflon, Polyesterfolie oder Keramik verwendet werden. Die Leiterbahnen bestehen aus den dem Fachmann bekannten leitenden Materialien, vorzugsweise Kupfer. In einer besonders bevorzugten Ausführungsform ist die erfindungsgemäße Leiterplatte eine Multilayer Verbundkeramik. Die Herstellung von entsprechenden Verbundkeramiken ist dem Fachmann bekannt.

Das Material für die erfindungsgemäßen Bondinseln wird so gewählt, dass es eine elektrische Verbindung zwischen der Leiterplatte und einem Bonddraht herstellt. Insbesondere wird das Material derart gewählt, dass die Bondinsel während des Bondingvorgangs orts- und formfest bleibt. Im Stand der Technik sind entsprechende Materialien, beispielsweise Metalle oder Metallpulver enthaltende Klebstoffe bekannt. Vorzugsweise bestehen die erfindungsgemäßen Bondinseln aus Gold und/oder Aluminium.

Als Sensorchip kommen alle dem Fachmann bekannten für Röntgenstrahlen empfindlichen Sensorchips in Frage. Der Sensorchip kann etwa ein Si(Li)-Detektor, ein HPGe-Detektor, eine PIN-Diode, ein aus Verbindungshalbleitern bestehender Detektor, ein SDD mit externen Transistoren oder ein Silizium-Driftdetektor mit integriertem FET (I-FET SDD) sein. Insbesondere handelt es sich bei dem erfindungsgemäß verwendeten Sensorchip um einen Silizium-Driftdetektor. Der Sensorchip im erfindungsgemäßen Sensorkopf weist eine viereckige oder achteckige Fläche auf. Vorzugsweise ist die Fläche des Sensorchips kleiner oder gleichgroß der Stirnfläche der Leiterplatte.

Zur Stabilisierung der thermischen Verhältnisse und gegebenenfalls zur Erzeugung von Arbeitstemperaturen, die unterhalb der Raumtemperatur liegen, kann in einer weiteren Ausgestaltung der Erfindung auf der von der Stirnfläche abgewandten Seite der Leiterplatte ein Kühlelement, insbesondere ein thermoelektrischer Kühler angeordnet sein.

Der thermoelektrische Kühler umfasst vorzugsweise mehrere Peltier-Elemente, die in einer Halterung angeordnet sind. Die Halterung stellt gleichzeitig die Kalt- und die Warmseite des thermoelektrischen Kühlers dar, wobei die Kaltseite die der Leiterplatte zugewandte Seite ist. In einer weiteren Ausführungsform ist die Kaltseite des thermoelektrischen Kühlers gleichzeitig die Leiterplatte. Die Diagonale der Kaltseite ist vorzugsweise größer, als die Diagonale der Warmseite des thermoelektrischen Kühlers.

In einer weiteren bevorzugten Ausführungsform werden als Signal- und Steueranschlüsse Kontaktstifte verwendet. Bei den erfindungsgemäßen Kontaktstiften handelt es sich um elektrisch leitende Materialien in Stiftform, vorzugsweise vergoldet. Zur Isolation und Vermeidung ungewollter elektrischer Leitung sind die Kontaktstifte vorzugsweise von einem röhrenförmigen Glaskörper umschlossen, der an beiden Enden offen ist und somit den Kontaktstift zur Kontaktierung freigibt.

Gemäß einer ersten Ausführungsform der Erfindung sind die Kontaktstifte auf der von der Stirnfläche abgewandten Seite der Leiterplatte derart angeordnet, dass sich die Längsachsen der Kontaktstifte im Lot mit den Seitenflächen der Leiterplatte befinden. An der der Leiterplatte zugewandten Seite der Kontaktstifte sind die Kontaktstifte über jeweils mindestens einen Bonddraht mit den Bondinseln an den Seitenflächen der Leiterplatte elektrisch leitend mit der Leiterplatte verbunden. Dabei befindet sich der Bonddraht vorzugsweise in einer Ebene mit den Seitenflächen der Leiterplatte und der Längsachse der Kontaktstifte.

Alternativ sind die Kontaktstifte derart angeordnet, dass sich die Längsachsen der Kontaktstifte im Lot mit dem Mittelpunkt der Aussparungen befinden. Dabei können die Kontaktstifte unterhalb der Aussparungen enden oder in diese hineinreichen. Vorzugsweise enden die Kontaktstifte in der Ebene der Stirnfläche der Leiterplatte. Die Bondinseln sind dann direkt neben den Aussparungen auf der Stirnfläche der Leiterplatte angeordnet. Das Bonden erfolgt bei dieser erfindungsgemäßen Lösung von oben.

Erfindungsgemäß ist zumindest ein Teil der vorhandenen Kontaktstifte mit den Bondinseln der Leiterplatte verbunden. Die Anzahl der gebondeten Kontaktstifte ergibt sich aus der Anzahl der benötigten Signal- und Steueranschlüsse. Insbesondere sind mindestens sechs der Kontaktstifte als Signal- und Steueranschlüsse mit der Leiterplatte verbunden. Zwei weitere Kontaktstifte werden vorzugsweise mit dem thermoelektrischen Kühler verlötet.

In einer weiteren Ausgestaltung ist die Leiterplatte mit der von der Stirnfläche abgewandten Seite auf einem Sockel angeordnet. Der Sockel dient zur mechanischen Befestigung der Bauteile des Sensorkopfes. Vorzugsweise besteht der Sockel aus einem Material mit einer guten Wärmeleitfähigkeit. Geeignete Materialien sind dem Fachmann bekannt, insbesondere wird Kupfer zur Herstellung des Sockels verwendet.

Auf der von der Stirnfläche abgewandten Seite ist auf dem Sockel in einer bevorzugten Ausführungsform weiterhin eine Bodenplatte angeordnet. Diese Bodenplatte weist Bohrungen auf, in denen die Glaskörper, welche die Kontaktstifte enthalten, angeordnet sind. Vorzugsweise entspricht die Länge der Glaskörper der Dicke der Bodenplatte.

In einer bevorzugten Ausführungsform ist die Bodenplatte als Ring ausgestaltet, wobei der Sockel durch die zentrale Öffnung der Bodenplatte geführt wird. Die Bodenplatte kann aus allen dem Fachmann bekannten Materialien gefertigt sein, die eine ausreichende Festigkeit aufweisen und in denen das Einfügen von den Bohrungen möglich ist. Insbesondere wird die Bodenplatte aus Edelstahl gefertigt.

Durch die erfindungsgemäße Anordnung der Bondinseln, der Bonddrähte und der Kontaktstifte werden vorteilhafte, zum Teil unvorhergesehene Effekte erzielt. Zunächst einmal gelingt es, gegenüber dem im Stand der Technik verwendeten Bonding mittels Schlaufen, den Bonddraht in einer kürzeren und damit direkten Verbindung zwischen dem Kontaktstift und der Bondinsel zu führen. Dies stellt eine deutliche Verbesserung des Stands der Technik dar.

Darüber hinaus werden die Bonddrähte nicht mehr wie im Stand der Technik üblich von oben auf den Bondinseln kontaktiert, sondern seitlich. Dies führt ebenfalls zu einer Verkürzung des Bonddrahts und der Vermeidung der platzaufwendigen Schlaufenbildung.

Die erfindungsgemäße Bondinganordnung ermöglicht die weitere vorteilhafte erfindungsgemäße Anordnung der übrigen Bauteile des Sensorkopfes. Insbesondere werden erfindungsgemäß die Kontaktstifte nicht wie üblich neben der Leiterplatte, sondern unterhalb, d.h. auf der von der Stirnfläche abgewandten Seite der Leiterplatte angeordnet, was zu einer deutlichen Reduzierung der räumlichen Ausdehnung des Sensorkopfes führt.

Der erfindungsgemäße Sensorkopf besitzt einen Durchmesser der kleiner als 14 mm, insbesondere kleiner als 13 mm, bevorzugter kleiner als 12 mm und noch bevorzugter kleiner als 11 mm ist, wobei eine aktive Fläche des Sensorchips 10 mm² beträgt. Somit erreicht man mittels der erfindungsgemäßen Anordnung gegenüber den im Stand der Technik bekannten Durchmessern von Sensorköpfen eine Reduzierung der räumliche Ausdehnung um bis zu über 25 % bei gleichzeitigem Erhalt der aktiven Fläche des Sensorchips.

Ein zweiter Aspekt der Erfindung betrifft einen Röntgendetektor, insbesondere einen EDX-Röntgendetektor, der den erfindungsgemäßen Sensorkopf enthält.

Die Erfindung wird nachfolgend anhand von Ausführungsbeispielen und den dazugehörigen Zeichnungen näher erläutert. Es zeigen:
- Fig. 1: einen grundsätzlichen Aufbau zur Elektronenstrahlmikroanalyse mit einem REM und einem Röntgendetektor 74;
- Fig. 2a,b: einen erfindungsgemäßen Sensorkopf 30 (Fig. 2b) im Vergleich zu einem Sensorkopf aus dem Stand der Technik (Fig. 2a) in der Seitenansicht;
- Fig. 3a - g: erfindungsgemäße Ausgestaltungen des erfindungsgemäßen Sensorkopfes 30 im Vergleich zu einem Sensorkopf aus dem Stand der Technik in der Aufsicht; und
- Fig. 3h: alternative erfindungsgemäße Ausgestaltung des erfindungsgemäßen Sensorkopfes 30 in der Aufsicht.

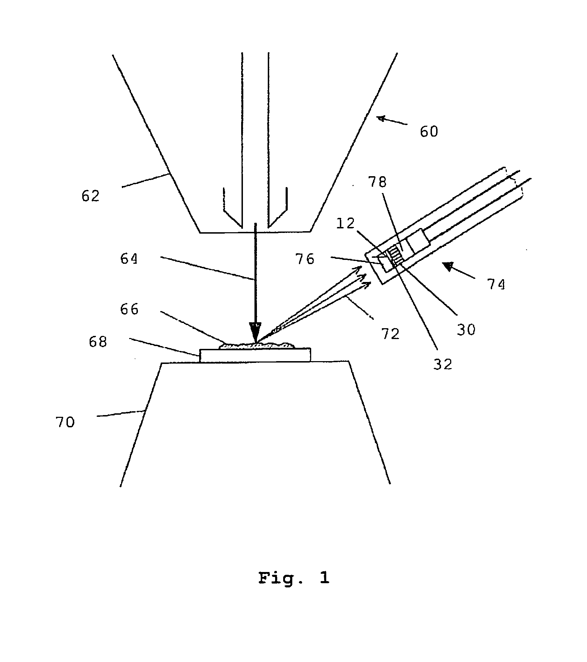

Fig. 1 zeigt eine Apparatur zur Elektronenstrahlmikroanalyse, bei der ein insgesamt mit 60 bezeichnetes REM einen Polschuh 62 aufweist, aus welchem ein Elektronenstrahl 64 austritt. Der Elektronenstrahl 64 ist auf eine Probe 66 gerichtet, die von einem Probenhalter 68 gehalten wird, welcher sich auf einem Probentisch 70 befindet. Der aus dem Polschuh 62 des Elektronenmikroskops 60 heraustretende Elektronenstrahl 64 regt die im Probenhalter 68 gehaltene Probe 66 an, infolge dessen Röntgenstrahlung 72 von der Probe 66 emittiert und nachfolgend in einem Röntgendetektor 74 detektiert wird.

Der EDX-Röntgendetektor 74, von dem hier lediglich der so genannte Kühlfinger dargestellt ist, weist einen Sensorkopf 30 mit einem Halbleiterkristall als Sensorchip 32 auf. Eine röntgensensitive Stirnfläche 12 des Sensorchips 32 wird von der eintretenden Röntgenstrahlung 72 bestrahlt. Rückseitig des Sensorkopfes 30 weist der Röntgendetektor 74 eine Kühlvorrichtung 78 auf, die insbesondere ein thermoelektrischer Kühler ist. Auf der der Röntgenstrahlung 72 zugewandten Seite des Sensorchips 32 befindet sich weiterhin eine Magnetfalle 76 deren Aufgabe es ist, Streuelektronen des Elektronenstrahls 64 abzulenken, um den Sensorchip 32 vor diesen zu schützen.

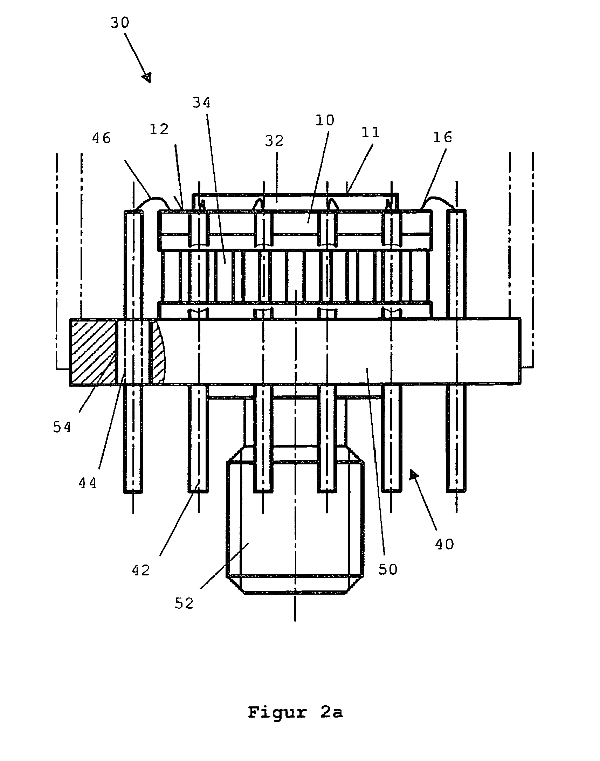

Fig. 2a zeigt einen Sensorkopf 30 für einen Röntgendetektor 74 gemäß dem Stand der Technik in der Seitenansicht. Ein Sensorchip 32, mit einer Fläche 11, die kleiner als eine Stirnfläche 12 einer Leiterplatte 10 ist, ist mittig auf der Stirnfläche 12 der Leiterplatte 10 montiert. In den freien Randbereichen der Stirnfläche 12 sind Bondinseln 16 vorhanden. Auf einer von der Stirnfläche 12 abgewandten Seite ist ein thermoelektrischer Kühler 34 angeordnet. Sensorchip 32, Leiterplatte 10 und thermoelektrischer Kühler 34 sind zur mechanischen Befestigung auf einem Sockel 52 montiert, der das Zentrum einer ringförmigen Bodenplatte 50 bildet. Der Durchmesser der Bodenplatte 50 ist größer als die Diagonale der Stirnfläche 12 der Leiterplatte 10. In den Randbereichen der Bodenplatte 50 befinden sich Bohrungen 54, die derart in der Bodenplatte 50 angeordnet sind, dass sie nicht durch die Stirnfläche 12 der Leiterplatte 10 abgedeckt werden. Die Bohrungen 54 nehmen röhrenförmige Glaskörper 44 mit sich darin befindenden Kontaktstiften 42 auf. Die Kontaktstifte 42 stellen zum Betrieb des Sensorchips 32 benötigte Signal- und Steueranschlüsse 40 dar. Die Länge der Glaskörper 44 entspricht der Dicke der Bodenplatte. Auf der dem Sensorchip 32 zugewandten Seite schließen die Kontaktstifte 42 mit der Stirnfläche 12 der Leiterplatte 10 bündig ab. Von den Enden der Kontaktstifte 42 führen Bonddrähte 46 in Form einer Schlaufe zu den Bondinseln 16 auf der Leiterplatte 10.

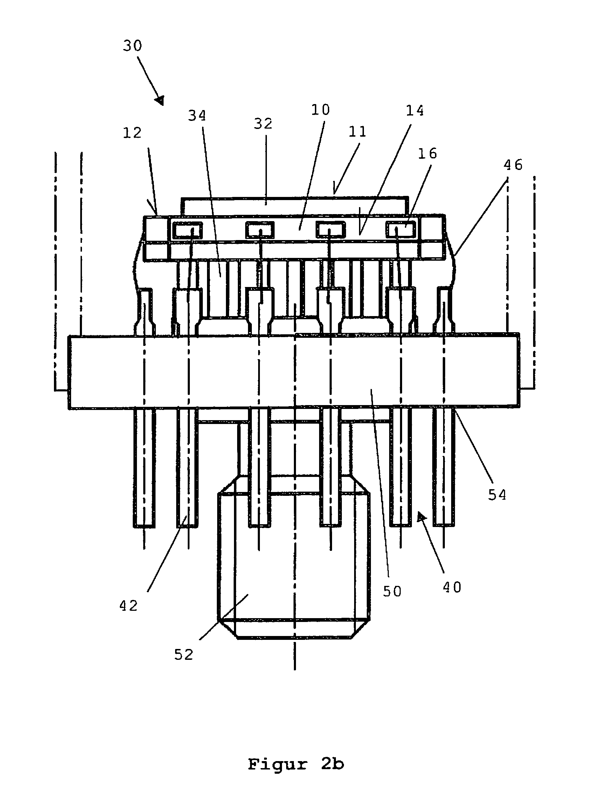

Fig. 2b zeigt den erfindungsgemäßen Sensorkopf 30 für den Röntgendetektor 74 in der Seitenansicht. Der Sensorchip 32 ist auf der Stirnfläche 12 der Leiterplatte 10 montiert. Im Unterschied zum Stand der Technik sind die Bondinseln 16 an den Seitenflächen 14 der Leiterplatte 10 lokalisiert. Auf der von der Stirnfläche 12 abgewandten Seite ist der thermoelektrische Kühler 34 angeordnet. Sensorchip 32, Leiterplatte 10 und thermoelektrischer Kühler 34 sind zur mechanischen Befestigung auf dem Sockel 52 montiert, der das Zentrum der ringförmigen Bodenplatte 50 bildet. Die Bodenplatte 50, weist die Bohrungen 54 auf, die die röhrenförmigen Glaskörper 44 mit den sich darin befindenden Kontaktstiften 42 aufnehmen. Die Kontaktstifte 42 stellen die zum Betrieb des Sensorchips 32 benötigten Signal- und Steueranschlüsse 40 dar. Dabei sind die Bohrungen 54 derart in der Bodenplatte 50 angeordnet, dass die Längsachse der Kontaktstifte 42 mit den Seitenflächen 14 der Leiterplatte 10 im Lot ist. Die Kontaktstiften 42 sind im Vergleich zum Stand der Technik auf der zur Leiterplatte 10 weisenden Seite verkürzt und stehen nur kurz aus der Bodenplatte 50 hervor. Von den Enden der Kontaktstifte 42 führen die Bonddrähte 46 als Verlängerung der Längsachse der Kontaktstifte 42 bis zu den Bondinseln 16 an den Seitenflächen 14 der Leiterplatte 10. Die Bonddrähte 46 sind seitlich an den Bondinseln 16 elektrisch leitend kontaktiert.

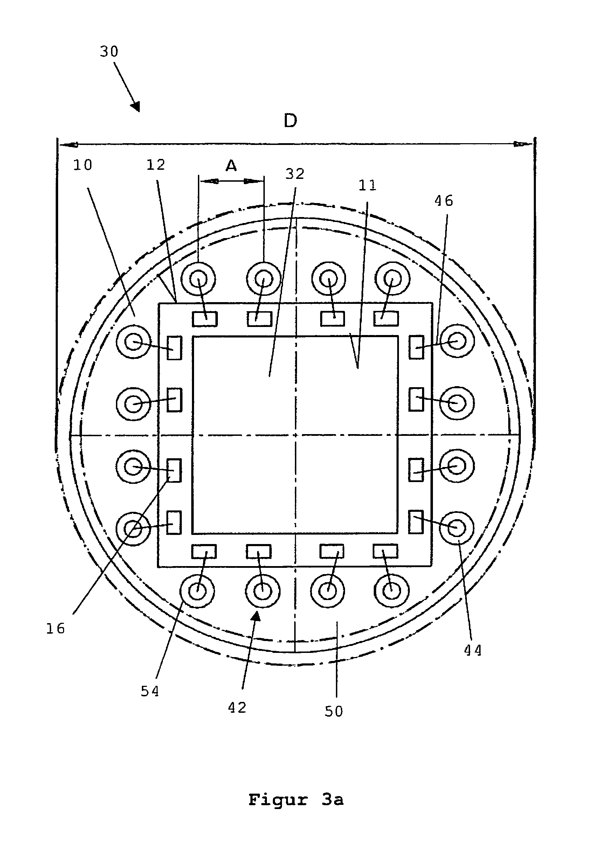

Die Fig. 3a zeigt den Sensorkopf 30 für den Röntgendetektor 74 gemäß dem Stand der Technik in der Aufsicht. Die Beschreibung der Bauteile des Sensorkopfes 30 erfolgt von oben nach unten. Der Sensorchip 32 und die darunter liegende Leiterplatte 10 besitzen eine quadratische Grundfläche, wobei die Stirnfläche 12 der Leiterplatte 10 größer als die Fläche 11 des Sensorchips 32 ist. Auf der Stirnfläche 12 der Leiterplatte 10 sind entlang der Seitenflächen des Sensorchips 32 jeweils vier Bondinseln 16 lokalisiert. Die Bondinseln 16 sind in regelmäßigen Abständen zueinander angeordnet. Der Abstand A zwischen den Mittelpunkten zweier Bondinseln 16 beträgt typischerweise 1,9 mm. Die Kontaktstifte 42 sind mit den Glaskörpern 44 in den Bohrungen 54 der Bodenplatte 50 angeordnet, wobei der Durchmesser der Bodenplatte 50 größer als die Diagonale der Stirnfläche 12 der Leiterplatte 10 ist, so dass die Kontaktstifte 42 außerhalb der Stirnfläche 12 der Leiterplatte 10 angeordnet werden. Es sind in der Regel mindestens acht, vorzugsweise acht bis 16 Kontaktstifte 42 in der Bodenplatte 50 angeordnet. Von den Enden der Kontaktstifte 42 führen die Bonddrähte 46 in Form einer Schlaufe zu den Bondinseln 16 auf der Stirnfläche 12 der Leiterplatte 10. Ein Durchmesser D des Sensorkopfes 30 gemäß des Stands der Technik beträgt typischerweise 14 mm bei einer aktiven Fläche des Sensorchips von 10 mm².

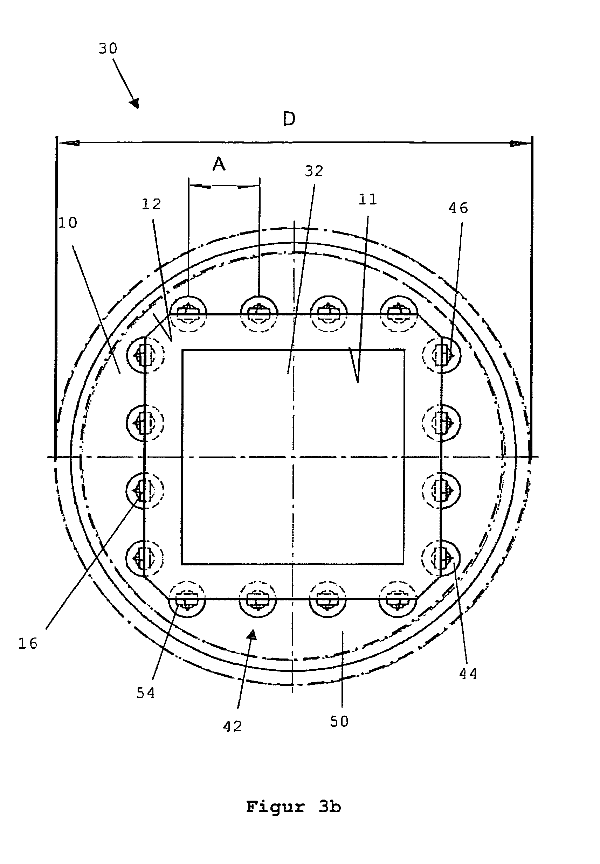

Fig. 3b zeigt den erfindungsgemäßen Sensorkopf 30 für den Röntgendetektor 74 in der Aufsicht. Die Beschreibung der Bauteile des Sensorkopfes 30 erfolgt von oben nach unten. Der Sensorchip 32 weist die viereckige Fläche 11 auf. Die sich daran anschließende Leiterplatte 10 weist die achteckige Stirnfläche 12 auf. Von kurzen Seitenflächen 20 und langen Seitenflächen 18 liegen sich jeweils zwei Seitenflächen gegenüber. Die gegenüberliegenden Seitenflächen sind gleichlang. Im Gegensatz zum Stand der Technik sind die Bondinseln 16 an den langen Seitenflächen 18 der Leiterplatte 10 lokalisiert. Es sind jeweils vier Bondinseln 16 pro langer Seitenfläche 18 in regelmäßigen Abständen zueinander angeordnet. Der Abstand A zwischen den Mittelpunkten zweier Bondinseln 16 beträgt 1,9 mm. Die Kontaktstifte 42 mit den Glaskörpern 44 sind in den Bohrungen 54 in der Bodenplatte 50 angeordnet, deren Durchmesser größer als die Diagonale der Stirnfläche 12 der Leiterplatte 10 ist. Es sind in der Regel mindestens acht, vorzugsweise acht bis 16 Kontaktstifte 42 in der Bodenplatte 50 in den Bohrungen 54 angeordnet. Die Längsachsen der Kontaktstifte 42 befinden sich im Lot mit den langen Seitenflächen 18. Die Bereiche der Kontaktstifte 42 und der Glaskörper 44, die sich unterhalb der Leiterplatte 10 befinden und dem Betrachter in der Aufsicht daher nicht zugänglich sind, sind zum besseren Verständnis als Schattenrisse gezeigt. Der Durchmesser D des Sensorkopfes 30 beträgt 12,8 mm.

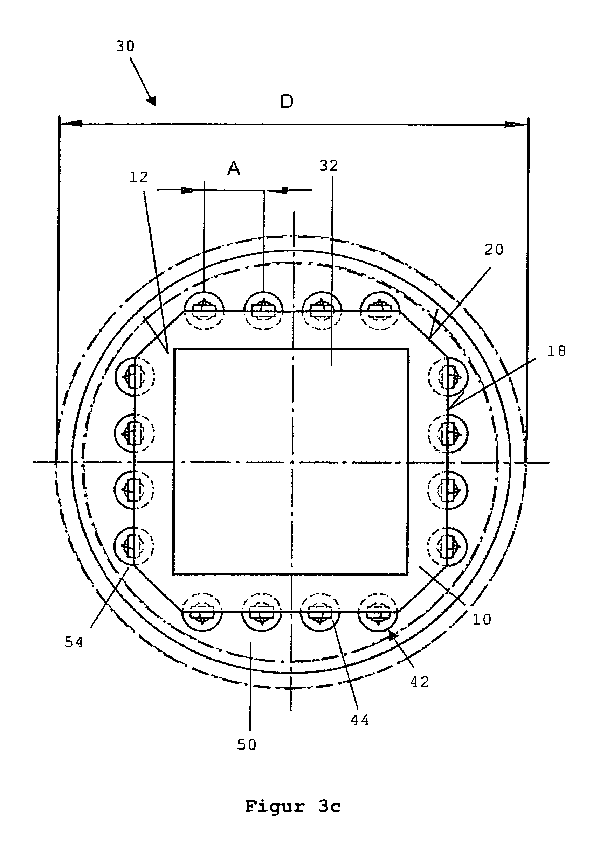

In den Fig. 3c - 3g sind weitere Ausgestaltungen des Sensorkopfes 30 gemäß der vorliegenden Erfindung dargestellt, die eine zunehmende Miniaturisierung erlauben.

Fig. 3c zeigt eine weitere vorteilhafte Ausgestaltung des erfindungsgemäßen Sensorkopfes 30 für den Röntgendetektor 74 in der Aufsicht. Der Aufbau des Sensorkopfes 30 entspricht dem in Fig. 3b erläuterten Aufbau. Die Bezugszeichen werden analog verwendet. Daher werden im folgenden nur die Abweichungen beschrieben. Die kurzen Seitenflächen 20 sind gegenüber der in Fig. 3b gezeigten Ausführungsform verlängert, so dass die Stirnfläche 12 der Leiterplatte 10 dadurch verkleinert wurde. Der Abstand A zwischen den Mittelpunkten zweier Bondinseln 16 beträgt 1,5 mm. Der Durchmesser D des Sensorkopfes 30 beträgt 12 mm.

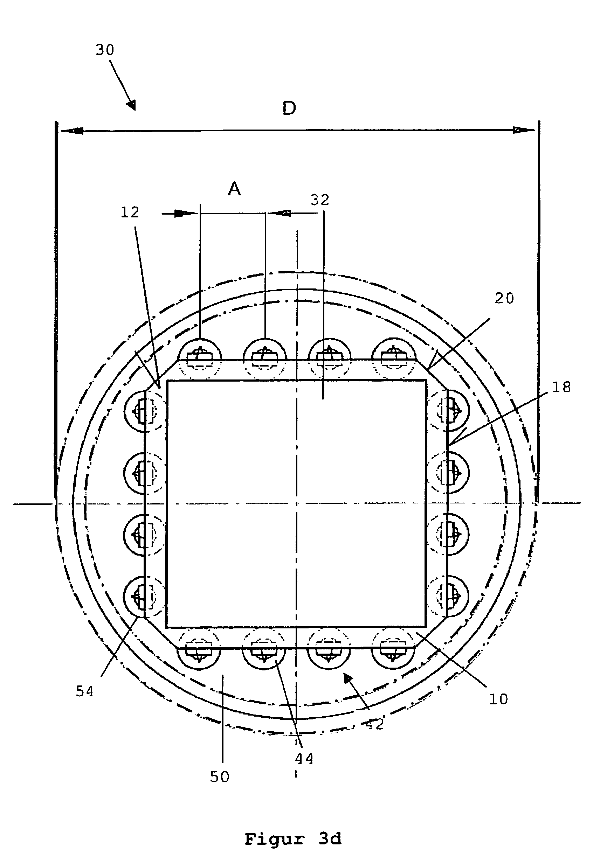

Fig. 3d wie Fig. 3c. Die Stirnfläche 12 der Leiterplatte 10 wurde weiter verkleinert. Der Durchmesser D des Sensorkopfes 30 beträgt 11,2 mm.

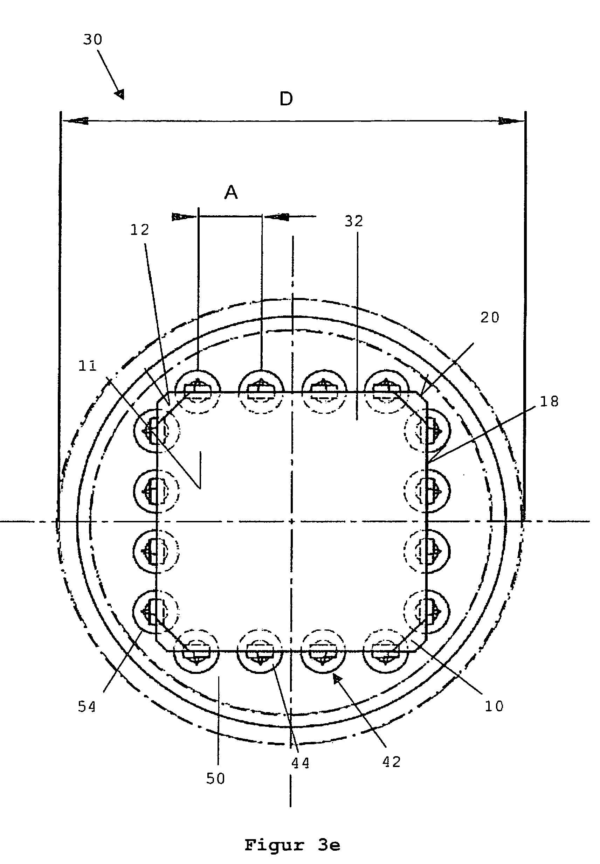

Fig. 3e wie Fig. 3d. Die Fläche 11 des Sensorchips 32 ist ebenso wie die Stirnfläche 12 der Leiterplatte 10 als Achteck ausgestaltet. Die langen Seitenflächen des Sensorchips 30 befinden sich im Lot mit den langen Seitenflächen 18 der Leiterplatte 10 und sind kürzer ausgestaltet. Die kurzen Seitenflächen des Sensorchips sind länger als die kurzen Seitenflächen 20 der Leiterplatte 10. Der Abstand A zwischen den Mittelpunkten zweier Bondinseln 16 beträgt 1,4 mm. Der Durchmesser D des Sensorkopfes 30 beträgt 10,3 mm.

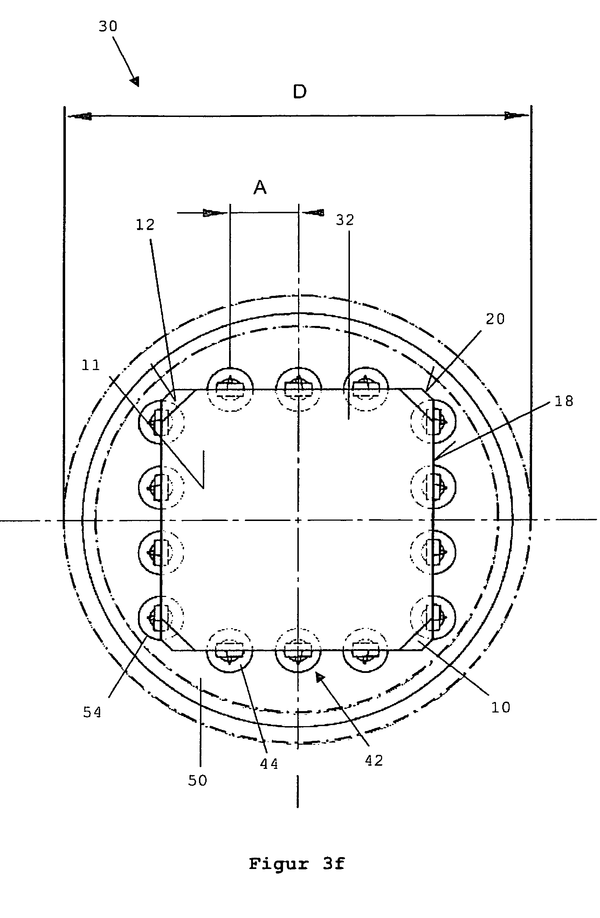

Fig. 3f wie Fig. 3e. An zwei gegenüberliegenden langen Seitenflächen 18 der Leiterplatte 10 sind drei Bondinseln 16 regelmäßig angeordnet, an den anderen beiden Seitenflächen 18 vier Bondinseln 16. Der Abstand A zwischen den Mittelpunkten zweier Bondinseln 16 beträgt 1,5 mm.

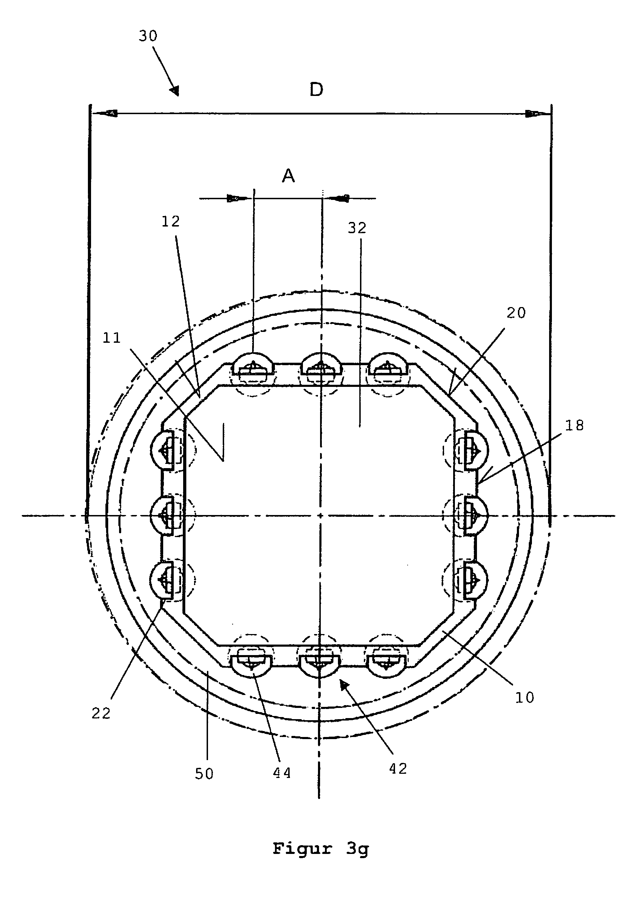

Fig. 3g wie Fig. 3f. Die langen Seitenflächen 18 der Leiterplatte 10 weisen jeweils drei Aussparungen 22 auf. In den Aussparungen 22 sind die Bondinseln 16 angeordnet. Somit sind an jeder langen Seitenfläche 18 der Leiterplatte 10 drei Bondinseln 16 angeordnet. Die Stirnfläche 12 der Leiterplatte 10 ist genau soviel größer als die Fläche 11 des Sensorchips 32, dass der Sensorchip 32 nicht über die Aussparungen 22 hinausragt.

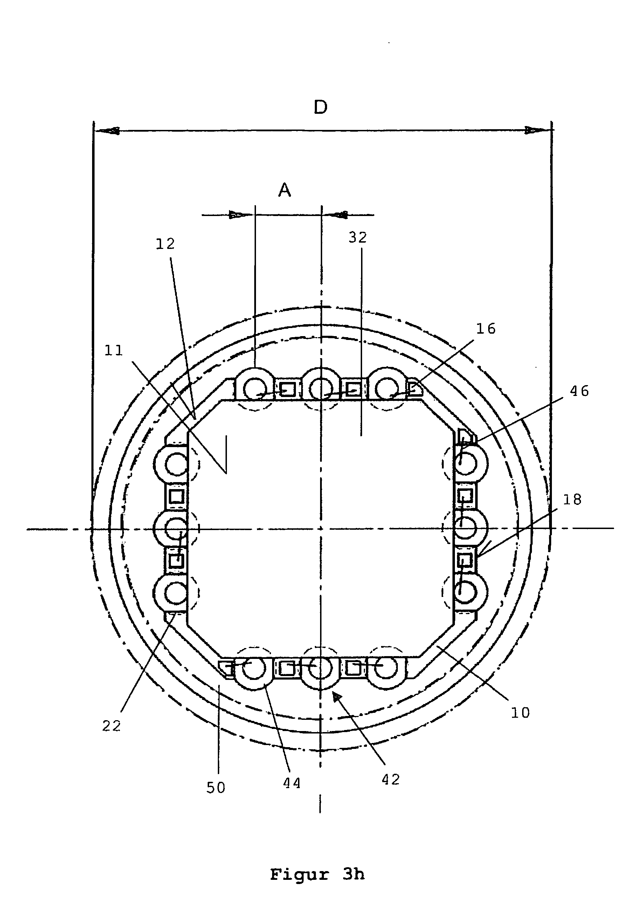

Fig. 3h zeigt eine alternative Lösung der erfindungsgemäßen Aufgabe. Die Leiterplatte 10 weist an den langen Seitenflächen 18 jeweils drei Aussparungen 22 auf. Die Kontaktstifte 42 sind derart angeordnet, dass sich die Längsachsen der Kontaktstifte 42 im Lot mit dem Mittelpunkt der Aussparungen 22 befinden. Dabei sind die Kontaktstifte 42 unterhalb der Leiterplatte 10 angeordnet, wobei die Enden allerdings von oben zugänglich sind. Die Kontaktstifte 42 enden vorzugsweise in der Ebene der Stirnfläche 12 der Leiterplatte 10. Die Bondinseln 16 sind erfindungsgemäß direkt neben den Aussparungen 22 auf der Stirnfläche 12 der Leiterplatte 10 angeordnet. Das Bonden erfolgt bei dieser erfindungsgemäßen Lösung von oben.

### Bezugszeichenliste

- 10: Leiterplatte
- 11: Fläche
- 12: Stirnfläche
- 14: Seitenfläche
- 16: Bondinsel
- 18: lange Seitenfläche
- 20: kurze Seitenfläche
- 22: Aussparung
- 30: Sensorkopf
- 32: Sensorchip
- 34: thermoelektrischer Kühler
- 40: Signal- und Steueranschluss
- 42: Kontaktstift
- 44: Glaskörper
- 46: Bonddraht
- 50: Bodenplatte
- 52: Sockel
- 54: Bohrung
- 60: REM
- 62: Polschuh
- 64: Elektronenstrahl
- 66: Probe
- 68: Probenhalter
- 70: Probentisch
- 72: Röntgenstrahlung
- 74: Röntgendetektor
- 76: Magnetfalle
- 78: Kühlvorrichtung
- D: Durchmesser
- A: Abstand

## Patentansprüche

1. Sensorkopf (30) für einen Röntgendetektor (74), umfassend
- eine Leiterplatte (10) mit einer Stirnfläche (12) und Seitenflächen (14),
- einen auf der Stirnfläche (12) der Leiterplatte (10) angeordneten für Röntgenstrahlung (72) empfindlichen Sensorchip (32),
- eine Mehrzahl von Signal- und Steueranschlüssen (40) zum Betrieb des Sensorchips (32), die unterhalb, d.h. auf der von der Stirnfläche (12) abgewandten Seite, der Leiterplatte (10) angeordnet sind,
- eine Mehrzahl von an der Leiterplatte (10) kontaktierend angeordneten Bondinseln (16), von denen mindestens ein Teil über jeweils mindestens einen Bonddraht (46) mit den Signal- und Steueranschlüssen (40) elektrisch leitfähig verbunden ist,
**gekennzeichnet durch** eine der Maßnahmen a) und b) :
a) die Bondinseln (16) sind an den Seitenflächen (14) der Leiterplatte (10) angeordnet
und
b) die Leiterplatte (10) weist an den Seitenflächen (14) Aussparungen (22) auf, wobei die Bondinseln (16) auf der Stirnfläche (12) der Leiterplatte (10) jeweils neben einer Aussparung (22) angeordnet sind und die Signal- und Steueranschlüsse (40)
b1) auf der von der Stirnseite (12) abgewandten Seite der Leiterplatte (10) unterhalb der Aussparungen (22) enden oder
b2) in die Aussparungen (22) hineinreichen.

2. Sensorkopf (30) nach Anspruch 1, **dadurch gekennzeichnet, dass** die Stirnfläche (12) der Leiterplatte (10) einen achteckigen Umriss aufweist, insbesondere mit vier einander gegenüberliegenden langen Seitenflächen (18) und vier einander gegenüberliegenden kurzen Seitenflächen (20).

3. Sensorkopf (30) nach Anspruch 2, **dadurch gekennzeichnet, dass** die Bondinseln (16) an den langen Seitenflächen (18) der achteckigen Grundfläche der Leiterplatte (10) angeordnet sind.

4. Sensorkopf (30) nach einem der Ansprüche 2 oder 3, **dadurch gekennzeichnet, dass** die Anzahl der Bondinseln (16) pro langer Seitenfläche (18) zwei bis acht, insbesondere drei bis sechs, vorzugsweise drei oder vier beträgt.

5. Sensorkopf (30) nach einem der Ansprüche 1 bis 4, sofern auf Anspruch 1, Alternative a) bezogen, **dadurch gekennzeichnet, dass** die Leiterplatte (10) an den Seitenflächen (14) Aussparungen (22)aufweist und die Bondinseln (16) in den Aussparungen (22) angeordnet sind.

6. Sensorkopf (30) nach einem der Ansprüche 1 bis 5, **dadurch gekennzeichnet, dass** die Bondinseln (16) aus Aluminium oder Gold sind.

7. Sensorkopf (30) nach einem der Ansprüche 1 bis 6, **dadurch gekennzeichnet, dass** die Leiterplatte (10) eine Multilayer Verbundkeramik ist.

8. Sensorkopf (30) nach einem der Ansprüche 1 bis 7, **dadurch gekennzeichnet, dass** ein Durchmesser (D) des Sensorkopfes (30) kleiner als 14 mm, insbesondere kleiner als 13 mm, bevorzugter kleiner als 12 mm und noch bevorzugter kleiner als 11 mm ist, wobei eine aktive Fläche des Sensorchips (32) 10 mm² beträgt.

9. Sensorkopf (30) nach einem der Ansprüche 1 bis 8, **dadurch gekennzeichnet, dass** auf einer von der Stirnfläche (12) abgewandten Seite der Leiterplatte (10) ein Kühlelement, insbesondere ein thermoelektrischer Kühler (34) angeordnet ist.

10. Sensorkopf (30) nach einem der Ansprüche 1 bis 9, **dadurch gekennzeichnet, dass** der Sensorchip (32) eine viereckige oder achteckige Fläche (11) aufweist, die insbesondere kleiner oder gleichgroß der Stirnfläche (12) der Leiterplatte (10) ist.

11. Sensorkopf (30) nach einem der Ansprüche 1 bis 10, **dadurch gekennzeichnet, dass** die Signal- und Steueranschlüsse (40) Kontaktstifte (42) sind, die insbesondere einen Glaskörper (44) aufweisen.

12. Sensorkopf (30) nach Anspruch 11, **dadurch gekennzeichnet, dass** die Kontaktstifte (42) auf der von der Stirnfläche (12) abgewandten Seite der Leiterplatte (10) angeordnet sind, wobei die Kontaktstifte (42) vollständig oder teilweise von der Stirnfläche (12) der Leiterplatte (10) verdeckt werden.

13. Sensorkopf (30) nach Anspruch 11 oder 12, **dadurch gekennzeichnet, dass** die Leiterplatte (10) mit der von der Stirnfläche (12) abgewandten Seite auf einem Sockel (52) angeordnet ist.

14. Sensorkopf (30) nach Anspruch 13, **dadurch gekennzeichnet, dass** auf der von der Stirnfläche (12) abgewandten Seite auf dem Sockel (52) eine Bodenplatte (50) angeordnet ist, wobei die Bodenplatte (50) Bohrungen (54) aufweist, in denen die Glaskörper (44) umfassend die Kontaktstifte (42) angeordnet sind.

15. Röntgendetektor (74), insbesondere EDX-Röntgendetektor, mit einem Sensorkopf (30) nach einem der Ansprüche 1 bis 14.

## Claims

1. A sensor head (30) for an X-ray detector (74), comprising
- a printed circuit board (10) with an end surface (12) and side surfaces (14),
- a sensor chip (32) that is arranged on the end surface (12) of the printed circuit board (10) and is sensitive to X-ray radiation (72),
- a plurality of signal and control terminals (40) for operation of the sensor chip (32), which are arranged below the printed circuit board (10), i.e. on the side facing away from the end surface (12) of said printed circuit board,
- a plurality of bonding islands (16) that are arranged on the printed circuit board (10) in a contacting manner and of which at least a part is connected to the signal and control terminals (40) in an electrically conductive manner by means of at least one bonding wire (46) in each case,
**characterized by** either of the measures a) and b):
a) the bonding islands (16) are arranged on the side surfaces (14) of the printed circuit board (10),
and
b) the printed circuit board (10) has recesses (22) on the side surfaces (14), wherein the bonding islands (16) are arranged on the end surface (12) of the printed circuit board (10), next to a recess (22) in each case, and the signal and control terminals (40)
b1) end on the side of the printed circuit board (10) facing away from the end surface (12), below the recesses (22), or
b2) extend into the recesses (22).

2. A sensor head (30) according to claim 1, **characterized in that** the end surface (12) of the printed circuit board (10) has an octagonal contour, in particular with four long side surface (18) that are opposite one another and four short side surfaces (20) that are opposite one another.

3. A sensor head (30) according to claim 2, **characterized in that** the bonding islands (16) are arranged on the long side surfaces (18) of the octagonal base of the printed circuit board (10).

4. A sensor head (30) according to either of claims 2 or 3, **characterized in that** the number of bonding islands (16) per long side surface (18) is two to eight, in particular three to six, preferably three or four.

5. A sensor head (30) according to any one of claims 1 to 4, if referring to claim 1, alternative a), **characterized in that** the printed circuit board (10) has recesses (22) on the side surfaces (14) and the bonding islands (16) are arranged in the recesses (22).

6. A sensor head (30) according to any one of claims 1 to 5, **characterized in that** the bonding islands (16) are made of aluminium or gold.

7. A sensor head (30) according to any one of claims 1 to 6, **characterized in that** the printed circuit board (10) is a multilayer ceramic composite.

8. A sensor head (30) according to any one of claims 1 to 7, **characterized in that** a diameter (D) of the sensor head (30) is smaller than 14 mm, in particular smaller than 13 mm, preferably smaller than 12 mm and even more preferred smaller than 11 mm, wherein an active surface of the sensor chip (32) is 10 mm².

9. A sensor head (30) according to any one of claims 1 to 8, **characterized in that** a cooling element, in particular a thermoelectric cooling element (34), is arranged on a side of the printed circuit board (10) facing away from the end surface (12).

10. A sensor head (30) according to any one of claims 1 to 9, **characterized in that** the sensor chip (32) has a quadrangular or octagonal surface (11), which in particular is smaller than or of the same size as the end surface (12) of the printed circuit board (10).

11. A sensor head (30) according to any one of claims 1 to 10, **characterized in that** the signal and control terminals (40) are contact pins (42), which in particular comprise a glass body (44).

12. A sensor head (30) according to claim 11, **characterized in that** the contact pins (42) are arranged on the side of the printed circuit board (10) facing away from the end surface (12), wherein the contact pins (42) are covered by the end surface (12) of the printed circuit board (10), either completely or in part.

13. A sensor head (30) according to claim 11 or 12, **characterized in that** the side of the printed circuit board (10) facing away from the end surface (12) is arranged on a support (52).

14. A sensor head (30) according to claim 13, **characterized in that** a bottom plate (50) is arranged on the support (52) on the side facing away from the end surface (12), wherein the bottom plate (50) has boreholes (54) in which the glass bodies (44) comprising the contact pins (42) are arranged.

15. An X-ray detector (74), in particular an ED X-ray detector, including a sensor head (30) according to any one of claims 1 to 14.

## Revendications

1. Tête de détection (30) pour un détecteur de rayons X (74), comprenant
- une plaquette de circuit imprimé (10) avec une face frontale (12) et des faces latérales (14),
- une puce de détecteur (32) sensible aux rayons X (72) et disposée sur la face frontale (12) de la plaquette de circuit imprimé (10),
- une multiplicité de connexions de signaux et de commande (40) pour le fonctionnement de la puce de détecteur (32) qui sont disposées au-dessous, c'est-à-dire sur le côté opposé à la face frontale (12), de la plaquette de circuit imprimé (10),
- une multiplicité de plots de connexion (16) disposés en réalisant le contact sur la plaquette de circuit imprimé (10), dont au moins une partie est raccordée de façon électriquement conductrice aux connexions de signaux et de commande (40) par le biais respectivement d'au moins un fil de connexion (46),
**caractérisée par** une des dispositions a) et b) :
a) les plots de connexion (16) sont disposés sur les faces latérales (14) de la plaquette de circuit imprimé (10) et
b) la plaquette de circuit imprimé (10) présente sur les faces latérales (14) des évidements (22), les plots de connexion (16) étant disposés sur la face frontale (12) de la plaquette de circuit imprimé (10) respectivement près d'un évidement (22), et les connexions de signaux et de commande (40)
b1) se terminant, sur le côté de la plaquette de circuit imprimé (10) opposé à la face frontale (12), au-dessous des évidements (22) ou
b2) allant jusque dans les évidements (22).

2. Tête de détection (30) selon la revendication 1, **caractérisée en ce que** la face frontale (12) de la plaquette de circuit imprimé (10) présente un périmètre octogonal, en particulier avec quatre faces latérales longues (18) opposées mutuellement et quatre faces latérales courtes (20) opposées mutuellement.

3. Tête de détection (30) selon la revendication 2, **caractérisée en ce que** les plots de connexion (16) sont disposés sur les faces latérales longues (18) de la face de base octogonale de la plaquette de circuit imprimé (10).

4. Tête de détection (30) selon une des revendications 2 ou 3, **caractérisée en ce que** le nombre de plots de connexion (16) par face latérale longue (18) est de deux à huit, en particulier de trois à six, de préférence de trois ou quatre.

5. Tête de détection (30) selon une des revendications 1 à 4, dans la mesure où on se réfère à la revendication 1, alternative a), **caractérisée en ce que** la plaquette de circuit imprimé (10) présente des évidements (22) sur les faces latérales (14), et **en ce que** les plots de connexion (16) sont disposés dans les évidements (22).

6. Tête de détection (30) selon une des revendications 1 à 5, **caractérisée en ce que** les plots de connexion (16) sont en aluminium ou en or.

7. Tête de détection (30) selon une des revendications 1 à 6, **caractérisée en ce que** la plaquette de circuit imprimé (10) est une céramique composite multicouche.

8. Tête de détection (30) selon une des revendications 1 à 7, **caractérisée en ce qu'**un diamètre (D) de la tête de détection (30) est inférieur à 14 mm, en particulier inférieur à 13 mm, de préférence inférieur à 12 mm et encore plus de préférence inférieur à 11 mm, une face active de la puce de détecteur (32) étant égale à 10 mm².

9. Tête de détection (30) selon une des revendications 1 à 8, **caractérisée en ce que**, sur un côté de la plaquette de circuit imprimé (10) opposé à la face frontale (12), il est disposé un élément de refroidissement, en particulier un refroidisseur thermoélectrique (34).

10. Tête de détection (30) selon une des revendications 1 à 9, **caractérisée en ce que** la puce de détecteur (32) présente une face quadrangulaire ou octogonale (11), qui est en particulier inférieure ou égale à la face frontale (12) de la plaquette de circuit imprimé (10).

11. Tête de détection (30) selon une des revendications 1 à 10, **caractérisée en ce que** les connexions de signaux et de commande (40) sont des broches de contact (42) qui présentent en particulier un corps en verre (44).

12. Tête de détection (30) selon la revendication 11, **caractérisée en ce que** les broches de contact (42) sont disposées sur le côté de la plaquette de circuit imprimé (10) opposé à la face frontale (12), les broches de contact (42) étant totalement ou partiellement couvertes par la face frontale (12) de la plaquette de circuit imprimé (10).

13. Tête de détection (30) selon la revendication 11 ou 12, **caractérisée en ce que** la plaquette de circuit imprimé (10) avec le côté opposé à la face frontale (12) est disposée sur un socle (52).

14. Tête de détection (30) selon la revendication 13, **caractérisée en ce que**, sur le côté opposé à la face frontale (12), il est disposé une plaque de fond (50) sur le socle (52), la plaque de fond (50) présentant des alésages (54) dans lesquels les corps en verre (44) sont disposés en englobant les broches de contact (42).

15. Détecteur de rayons X (74), en particulier détecteur de rayons X à dispersion d'énergie, avec une tête de détection (30) selon une des revendications 1 à 14.
